# EUROPÄISCHE PATENTSCHRIFT

(11) **EP 1 112 530 B1**
(45) Veröffentlichungstag und Bekanntmachung des Hinweises auf die Patenterteilung: **14.04.2010**
(21) Anmeldenummer: 99900049.0
(22) Anmeldetag: 14.01.1999
(51) Int. Cl.: G03F 7/00, H05K 3/00

(54) **VERFAHREN ZUR MIKROLOCHERZEUGUNG**
METHOD FOR PRODUCING MICRO-OPENINGS
PROCEDE DE PRODUCTION DE MICRO-ORIFICES

(30) Priorität: 28.08.1998 CH 176398
(43) Veröffentlichungstag der Anmeldung: 04.07.2001
(73) Patentinhaber: Dyconex AG, 8303 Bassersdorf (CH)
(72) Erfinder: SCHMIDT, Walter, CH-8332 Russikon (CH)
(74) Vertreter: Frei, Alexandra Sarah
(86) Internationale Anmeldenummer: PCT/CH1999/000016
(87) Internationale Veröffentlichungsnummer: WO 2000/013062

(56) Entgegenhaltungen:
- EP-A- 0 490 586
- DE-A- 4 002 326
- US-A- 5 178 051
- US-A- 5 692 423
- "METHOD TO CONTROL THE GEOMETRY AND VERTICAL PROFILE OF VIA HOLES IN SUBSTRATE MATERIALS" IBM TECHNICAL DISCLOSURE BULLETIN, Bd. 35, Nr. 5, 1. Oktober 1992, Seiten 211-216, XP000312938
- PATENT ABSTRACTS OF JAPAN vol. 096, no. 007, 31. Juli 1996 & JP 08 083789 A (AGENCY OF IND SCIENCE &TECHNOL; MATSUSHITA ELECTRIC IND CO LTD), 26. März 1996

## Beschreibung

Die vorliegende Erfindung liegt auf dem Gebiet der Leiterplattentechnik und betrifft ein Verfahren zur Mikrolocherzeugung gemäss der Definition der Patentansprüche.

In der modernen Leiterplattentechnik werden vermehrt Mikrolöcher oder Micro-Vias eingesetzt, da die konventionell mechanisch gebohrten Z-Achsenverbindungen zu viel Platz wegnehmen. Es gibt eine Reihe von Herstellverfahren für Mikrolöcher in Halbzeugen für Leiterplatten. Neben dem Plasma-Bohren können auch das Laser-Bohren oder die photochemische Strukturierung zur Erzeugung von kleinen Löchern in photoempfindlichen Dielektrika eingesetzt werden.

Während das Laser-Bohren ein sequentieller Prozess ist, der bei grossen Lochzahlen naturgemäss auch lange Zeit beansprucht, sind das Plasma-Bohren und auch das Verfahren der photostrukturierten Mikrolöcher parallele Prozesse, die es erlauben, alle Löcher gleichzeitig herzustellen.

Die photochemische Strukturierung zeigt eine Reihe von Nachteilen, insbesondere das fehlerfreie Aufbringen von flüssigen, photoempfindlichen Dielektrika-Schichten ist sehr aufwendig und es ist deshalb auch schwierig eine hohe Ausbeute zu erreichen.

Das Plasma-Bohren wurde in einer Reihe von Patenten bereits schutzrechtlich abgesichert und hat sich seit 1991 Jahren sehr bewährt. Trotzdem gibt es einige Punkte, die noch verbesserungswürdig sind:
- Einerseits ist das Plasma-Bohren ein paralleler Prozess, d.h. alle Löcher werden gleichzeitig hergestellt. Der Vorgang dauert zwischen 10 und 45 Minuten, je nach Material und dessen Dicke. Die Bohrgeschwindigkeit ist für ein gegebenes Dielektrikum kaum mehr zu steigern und - insbesondere bei einer kleineren Anzahl von zu bohrenden Löchern - ist das Verfahren nicht so wirtschaftlich, als bei grossen Lochdichten. Es wäre daher von Vorteil, die Geschwindigkeit des Plasma-Bohrens noch weiter zu steigern, bzw. die Prozesszeit zu verkürzen.
- Das verwendete Plasma-Bohrverfahren ist ein beschränkt anisotroper Ätzprozess, der nicht nur in der Z-Richtung der Vorfabrikate, sondern auch lateral, in XY- Richtung angreift. Dadurch entsteht eine sogenannte Unterätzung, die insbesondere bei der Herstellung von Sacklöchern durch einen weiteren Prozess, das Lochforming, eliminiert werden muss. Dabei wird eine Lage elektrisch leitfähigen Materials homogen abgetragen und gleichzeitig überhängende Materialränder abgeätzt. Die Nachteile dieses Verfahrens sind einerseits die zusätzlichen Kosten, andererseits aber auch eine Vergrösserung der geätzten Löcher. Es wäre von Vorteil, diese Unterätzung zu vermindern bzw. zu vermeiden.
- Vor dem eigentlichen Plasma-Bohren werden in einem Photoprozess alle jene Stellen vom elektrisch leitfähigen Material befreit, an denen ein Loch geätzt werden soll. Dieser Photostrukturierprozess ist nicht ohne Ausbeuteeinbusse zu bewerkstelligen. Insbesondere können kleine Staubpartikel etc. dazu führen, dass nicht erwünschte, zusätzliche Öffnungen im elektrisch leitfähigen Material entstehen, die im Plasma ebenfalls zu Löchern werden, die anschliessend im galvanischen Durchplattieren zu elektrischen Kurzschlüssen führen können.

Die vorliegende Erfindung stellt sich somit zur Aufgabe, ein Verfahren zur Mikrolocherzeugung zu liefern, welches die oben beschriebenen Nachteile vermeidet. Dieses Verfahren soll kostengünstig, einfach einsetzbar und mit gängigen Techniken der Leiterplattenindustrie kompatibel sein.

Diese Aufgabe wird durch die in den Ansprüchen definierte Erfindung gelöst.

Die Erfindung basiert auf der Tatsache, dass eine Kombination eines Prägevorgangs mit anschliessender Lochreinigung verwendet wird und Prägewerkzeuge bzw. Prägevorrichtungen mit herkömmlichen Methoden günstig herstellbar sind. Solche Prägewerkzeuge bzw. Prägevorrichtungen werden hierbei insbesondere zur Erzeugung von Öffnungen im Dielektrikum verwendet. Sie lassen sich aber auch zum Entfernen von lokalen Bereichen elektrisch leitfähigen Materials verwenden. In einer Nachbehandlung werden die geprägten Mikrolöcher gereinigt und anschliessend nach den herkömmlichen Verfahren der Leiterplattentechnik elektrisch durchkontaktiert. Dieses Prägen von Mikrolöchern hat eine wesentliche Verkürzung der Prozesszeiten zur Folge und gestattet neue, sehr vorteilhafte Möglichkeiten.

Im folgenden wird die Erfindung anhand der folgenden Figuren im Detail erläutert, hierbei zeigt:
- Fig. 1: schematisch einen Teil eines Prägewerkzeuges,
- Fig. 2: schematisch einen Teil eines ersten beispielhaften Leiterplattenhalbzeuges, hergestellt unter Verwendung eines Prägewerkzeuges gemäss Fig. 1c,
- Fig. 3: schematisch einen Teil eines weiteren Leiterplattenhalbzeuges, hergestellt unter Verwendung eines Prägewerkzeuges gemäss Fig. 1c,
- Fig.4: schematisch einen Teil eines weiteren Prägewerkzeuges,
- Fig. 5: schematisch einen Teil eines weiteren beispielhaften Leiterplattenhalbzeuges, hergestellt unter Verwendung eines Prägewerkzeuges gemäss Fig. 4f,
- Fig. 6: schematisch einen Teil eines weiteren beispielhaften Leiterplattenhalbzeuges, hergestellt unter Verwendung eines Prägewerkzeuges gemäss Fig. 4f,
- Fig.7: schematisch einen Teil einer beispielhaften Prägevorrichtung,
- Fig. 8: schematisch einen Teil eines weiteren beispielhaften Leiterplattenhalbzeuges, hergestellt unter Verwendung einer Prägevorrichtung gemäss Fig. 7,
- Fig. 9: schematisch einen Teil eines weiteren Leiterplattenhalbzeuges, hergestellt unter Verwendung einer Prägevorrichtung gemäss Fig. 7,
- Fig. 10: schematisch einen Teil eines weiteren beispielhaften Leiterplattenhalbzeuges, hergestellt unter Verwendung eines Prägewerkzeuges oder einer Prägevorrichtung,
- Fig. 11: schematisch einen Teil eines weiteren beispielhaften Leiterplattenhalbzeuges, hergestellt unter Verwendung eines Prägewerkzeuges oder einer Prägevorrichtung,
- Fig. 12: schematisch einen Teil eines weiteren beispielhaften Leiterplattenhalbzeuges, hergestellt unter Verwendung eines Prägewerkzeuges oder einer Prägevorrichtung sowie unter Verwendung einer elastischen Zwischenschicht,
- Fig. 13: schematisch Teile zweier Prägewerkzeuge, ein weiteres beispielhaftes Prägewerkzeug gemäss Fig. 13a ist in einem weiteren vorteilhaften Herstellungsverfahren hergestellt, Fig. 13b zeigt ein nachteiliges Prägewerkzeug,
- Fig. 14: schematisch einen Teil eines weiteren beispielhaften Leiterplattenhalbzeuges mit gestanztem Fehler, hergestellt unter Verwendung eines nachteiligen Prägewerkzeuges gemäss Fig. 13b,
- Fig. 15: schematisch einen Teil eines weiteren Prägewerkzeuges,
Heutzutage werden in der Leiterplattentechnik vermehrt Sacklöcher angelegt. Dies liegt bspw. daran, dass die verwendeten Dielektrika-Schichten sehr dünn geworden sind. Ferner hat sich herausgestellt, dass Prägewerkzeuge bzw. Prägevorrichtungen relativ einfach und günstig mit bekannten Mitteln und Möglichkeiten der Leiterplattenfabrikation hergestellt werden können.

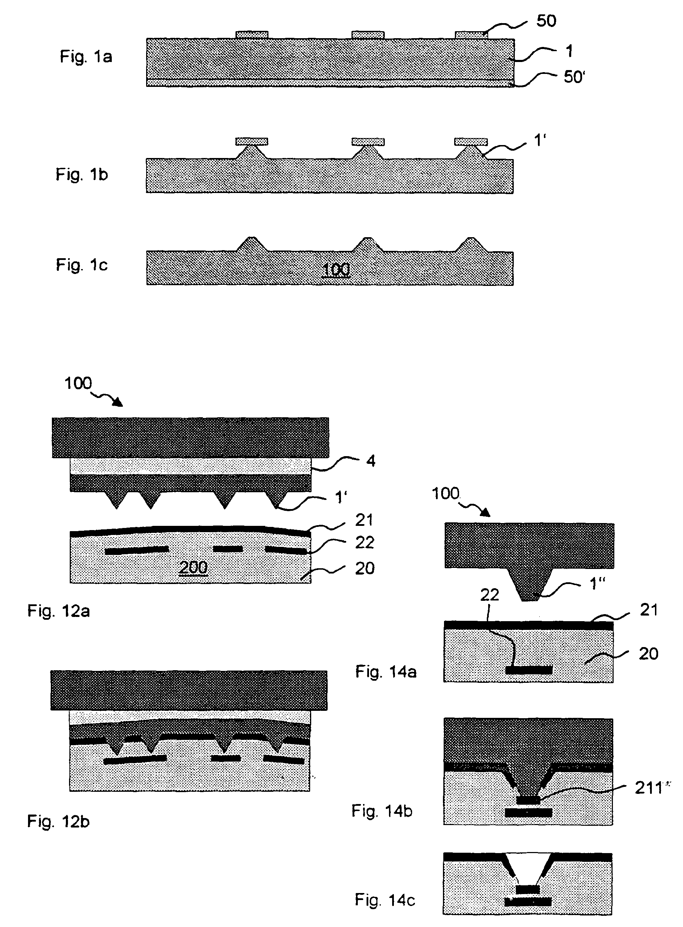

Fig. 1 zeigt schematisch einen Teil eines ersten Prägewerkzeuges 100, hergestellt in einem ersten vorteilhaften Herstellungsverfahren. Als Ausgangsmaterial dient eine Metallplatte 1, bspw. ein Blech. Diese Platte wird photochemisch, bspw. mittels belichtetem Photoresist 50,50' so bearbeitet, dass an allen Orten, an denen in Leiterplatten ein Mikroloch entstehen soll, eine konische Erhebung 1' herausgeätzt wird. Durch die Unterätzung im nasschemischen Prozess werden die Erhebungen, deren Höhe im Bereich von 25 bis 100 µm liegt, automatisch kegelförmig ausgebildet. Bei Kenntnis der vorliegenden Erfindung können natürlich auch andere Ausgangsmaterialien, bspw. nichtmetallische Platten und Folien verwendet werden.

Dieses so entstandene erste Prägewerkzeug kann 100% geprüft werden und dient als wiederverwendbares Werkzeug in der Fertigung von Halbzeugen für Leiterplatten. Insbesondere dient es als Werkzeug zur Herstellung von Sacklöchern in Leiterplattenhalbzeugen. Die konische Ausformung der Erhebungen ermöglicht ein einfaches Herausziehen/Lösen des Prägewerkzeuges vom Leiterplattenhalbzeug. Es erfolgen bspw. keine Beschädigungen oder Verunreinigungen des Halbzeuges. Dieses einfache Lösen des Werkzeuges vom Halbzeug erhöht die Prozessausbeute, da Nachfolgeprozesse, bspw. die Durchkontaktierung der Sacklöcher unter somit optimalen Bedingungen durchgeführt werden können.

Bei der Fertigung von Leiterplattenhalbzeugen werden vorteilhafterweise Vorfabrikate verwendet, die aus mehreren Schichten elektrisch leitfähigen Materials wie bspw. Kupfer bestehen, welche durch Dielektrikum voneinander getrennt sind.

Das Vorfabrikat kann ein mehr oder weniger vorgefertigtes Leiterplattenhalbzeug mit bereits in Schichten elektrisch leitfähigen Materials strukturierten Leiterbahnen sein. Dabei ist zu bemerken, dass das Dielektrikum zwischen zu verbindenden Lagen elektrisch leitfähigen Materials keine Glasfaserverstärkung aufweist und bevorzugterweise reines Harz darstellt. Dieses Harz, meist Epoxidharz oder Polyimid-Harz bzw. Mischungen verschiedener Kunststoffe, kann - muss aber nicht -vollständig ausgehärtet sein.

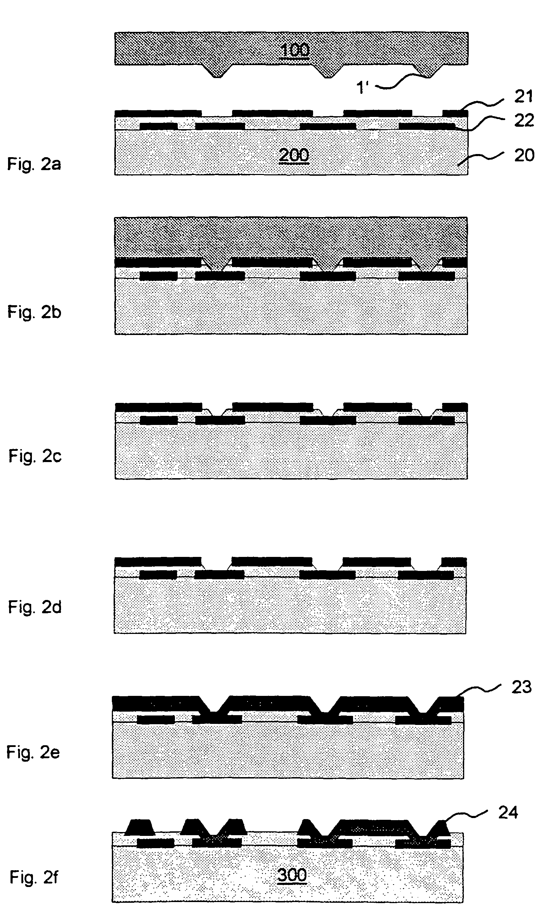

Fig. 2 zeigt ein erstes beispielhaftes Herstellungsverfahren von Leiterplattenhalbzeugen. In einem Positioniervorgang gemäss Fig. 2a wird ein im beispielhaften Herstellungsverfahren gemäss Fig. 1 hergestelltes Prägewerkzeug 100 gegenüber einem Vorfabrikat 200 für Leiterplattenhalbzeuge so positioniert, dass die Erhöhungen oder Spitzen 1 des Prägewerkzeuges mit vorstrukturierten Öffnungen in einer Kupferfläche 21 der Leiterplatten-Aussenseite lagemässig übereinstimmen. Diese lagemässige Aussrichtung an vorstrukturierten Öffnungen in der Leitmaterialfläche ist optional und nicht Bedingung, wie an weiteren Beispielen gezeigt wird.

In einem Pressvorgang gemäss den Fig. 2b und 2c wird nun die Matrize gegen das Vorfabrikat gepresst, wodurch sich die Spitzen in die vorgefertigten Kupferöffnungen hineindrücken und das Harz des Dielektrikums 20 lokal verdrängen. Dabei kann es auch sinnvoll sein, die Matrize zu erwärmen um das zu verdrängende Harz teigig werden zu lassen.

Durch Prägen alleine wird das Harz am Grunde der Vertiefungen nicht vollständig verdrängt. Dies macht eine gründliche Nachreinigung der Löcher erforderlich. Diese kann gemäss Fig. 2d mittels Plasma erfolgen, wobei im Unterschied zu dem normalen Plasma-Bohren nur wenig Material abgetragen werden muss, was die Prozesszeit wesentlich verkürzt. Zudem können auch nasschemische Verfahren, wie z.B. die Anwendung von stark oxidierenden Medien (Kaliumpermanganat-Lösungen), wie sie in der konventionellen Leiterplatten-Fertigung für die Lochreinigung verwendet werden, eingesetzt werden.

Gemäss Fig. 2e kann anschliessend das entstandene Leiterplattenhalbzeug 300 genau wie herkömmlich hergestellte mittels bekannter Verfahren mit elektrisch leitfähigem Material 23 wie bspw. Kupfer belegt und bis zur nächsten elektrisch leitfähigen Materialschicht 22 durchkontaktiert werden. Danach erfolgt gemäss Fig. 2f die photochemische Strukturierung der Leiterbahnen 24, etc.

Durch die stark verkürzte Prozesszeit im Plasma entsteht praktisch keine oder nur eine kleine, durchaus tolerierbare Unterätzung, d.h. die Aussenschicht muss bspw. nicht mehr abgedünnt werden um eventuelle Überhänge wegzuätzen. Dies ist ein weiterer Vorteil, der auch kostenmässig zu Buche schlägt. Zudem kann man auf diese Weise viel kleinere Löcher erzeugen.

Ein weiterer Vorteil liegt in der Tatsache, dass nur jene Löcher wirklich bis zur nächsten elektrisch leitfähigen Materialschicht durchgeätzt werden, die auch durch das Prägewerkzeug vorgelocht wurden, da bspw. die Plasma-Reinigung nicht ausreicht, an einem eventuell vorhandenen überzähligen Loch in der Kupferschicht ein Durchgangsloch zu erzeugen. Dadurch wird das oben genannte Problem der unerwünschten, zusätzlichen Löcher gelöst.

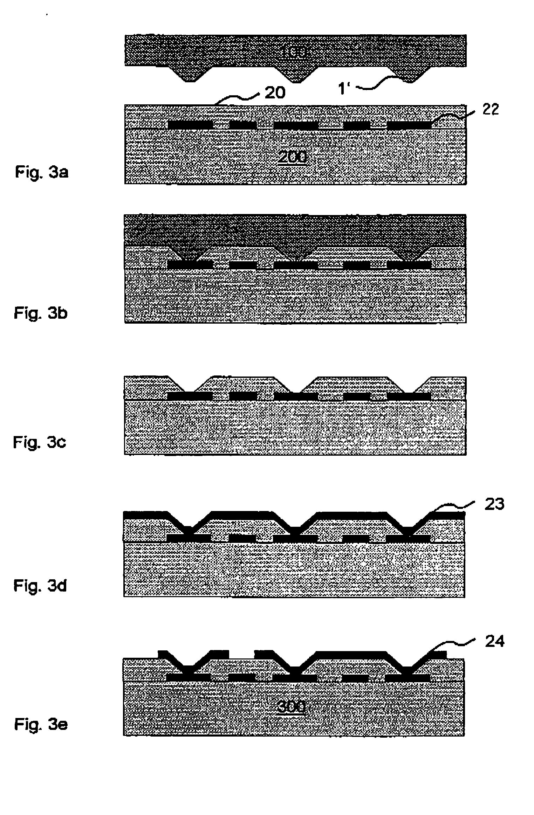

Fig. 3 zeigt ein Herstellungverfahren eines Leiterplattenhalbzeuges. Bei diesem weiteren Herstellungsverfahren eines Leiterplattenhalbzeuges 300 wird im Unterschied zu Fig. 2 ein Vorfabrikat 200 ohne äussere Leitmaterialoberfläche verwendet (Fig. 3a). Gemäss Fig. 3b und 3c werden bspw. Sacklöcher im Dielektrikum 20 mit dem Prägewerkzeug 100 geprägt und nachgereinigt. Gemäss Fig. 3d und Fig. 3e wird die gesamte exponierte Vorfabrikatoberfläche mit bekannten Verfahren mit elektrisch leitfähigem Material wie bspw. Kupfer 23 belegt, durchkontaktiert und photochemisch strukturiert. Insbesondere kann das Vorfabrikat durch stromlose (chemische) oder galvanische (elektrochemische) Verfahren mit elektrisch leitfähigem Material belegt werden

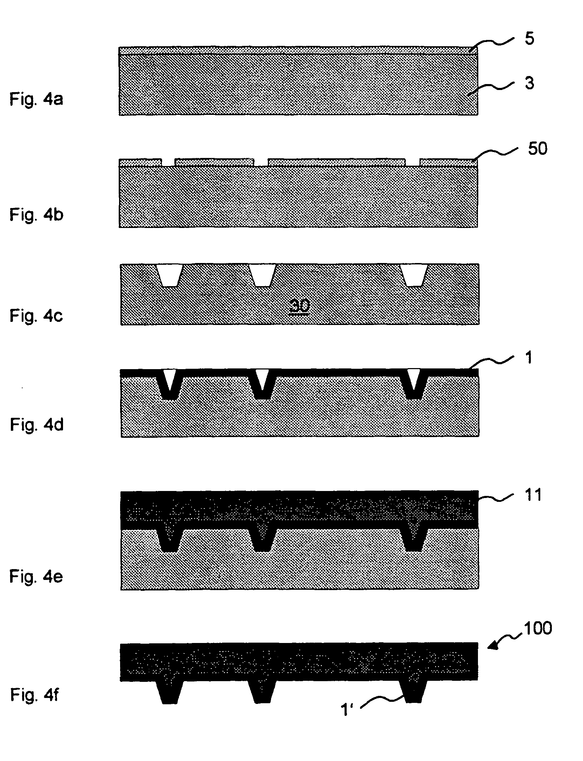

Das Prägewerkzeug kann wie im weiteren Herstellungsverfahren gemäss Fig. 4 gezeigt, auch durch andere bekannte Verfahren, wie z.B. durch Galvanoforming hergestellt werden. Dabei wird gemäss der Fig. 4a bis 4c aus einem Ausgangsmaterial 3 zuerst eine negative Urform 30 durch photochemische oder mechanische Bearbeitung (bspw. mittels Photoresist 5, der zu gehärtetem Photoresist 50 belichtet) hergestellt, die danach durch einen galvanischen Prozess mit z.B. einer Schicht Metall 1 belegt wird (Fig 4d). Je nach Dicke und Stabililität dieser aufgalvanisierten Metallschicht kann diese durch Aufbringen einer Trägerplatte 11 zusätzlich versteift werden (Fig. 4e). Dies ist jedoch keine Bedingung. Vorzugsweise aber nicht zwingenderweise ist die aufgalvanisierte Metallschicht eine Chromschicht, die auf der Urform schlecht haftet. Dies erleichtert das Ablösen des Prägewerkzeuges 100 von der Urform (Fig. 4f). Dem Fachmann stehen bei Kenntnis der vorliegenden Erfindung zahlreiche Variationen des Herstellungsverfahrens eines weiteren Prägewerkzeuges durch Galvanoforming zur Verfügung**.** Prinzipiell sind bei Kenntnis der vorliegenden Erfindung alle kostengünstigen Prägeverfahren einsetzbar.

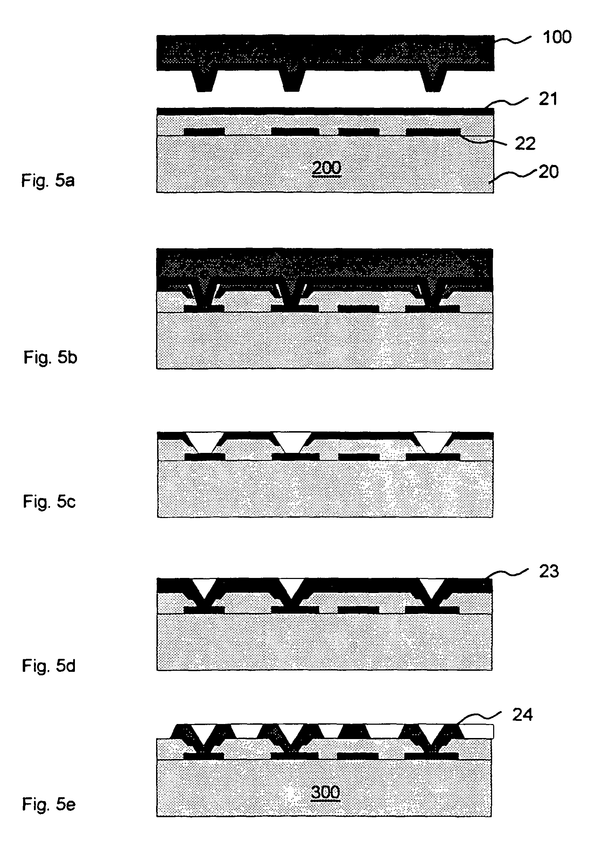

Durch dieses weitere Herstellungsverfahren können Prägewerkzeuge 100 oder Matrizen mit spitzeren Erhebungen 1' gefertigt werden. Eine solche Matrize kann man dazu verwenden, das Kupfer 21 der Aussenlage eines Vorfabrikats 200, ohne es vorher wegzuätzen, zu durchstossen, wodurch ein photochemischer Prozessschritt eliminiert werden kann (Fig. 5a). Das relativ weiche Kupfer wird dabei in die Mikrolöcher hineingedrückt und bildet eine bereits elektrisch leitfähige Seitenwand der Mikrolöcher (Fig. 5b).

Auch bei dieser Verfahrensvariante ist eine Nachreinigung, bspw, mittels Plasma oder nasschemischer Verfahren erforderlich (Fig. 5c). Anschliessend wird analog zu Fig. 2 die Oberfläche mittels bekannter Verfahren mit bspw. Kupfer 23 belegt und galvanisch verstärkt, wodurch auch die Mikrolöcher elektrisch leitend werden (Fig. 5d). Durch einen photochemischen Strukturierprnzess wird ein Leiterbild 24 in das Kupfer geätzt. Das Leiterplattenhalbzeug 300 ist fertig.

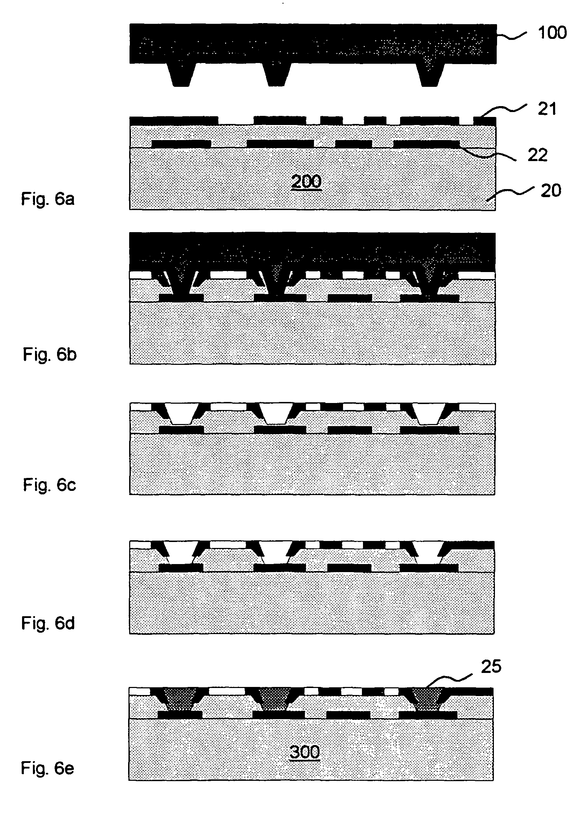

In einer Abwandlung des Verfahrens nach Fig. 5 kann man einen galvanischen Durehkontaktieningsgrozess durch das Einbringen eines elektrisch leitfähigen Klebers 25 in Löcher des Leiterplattenhalbzeuges 300 ersetzen (Fig. 6e), was insbesondere bei sehr kostensensiblen Leiterplatten oder Platinen im Bereich der Konsumelektronik angebracht erscheint. Das Einbringen kann durch einen Siebdruckprozess, durch Disperser, Bubble-Jet Prozess, etc. erfolgen.

Diese Prägeprozesse erlauben es, die Prozesszeit wesentlich zu verkürzen (bspw. um einen Faktor 5). Bei Verwendung von Plasma zur Nachreinigung mit aufgrund der im Vergleich zum Plasma-Bohren kurzen Plasrnareaktionszeit keine nachteilige Unterätzung auf, was die Ausbeute erhöht. Ferner wird die Ausbeute erhöht, da nur jene Löcher auch erzeugt werden, die auch durch die Prägematrize definiert sind.

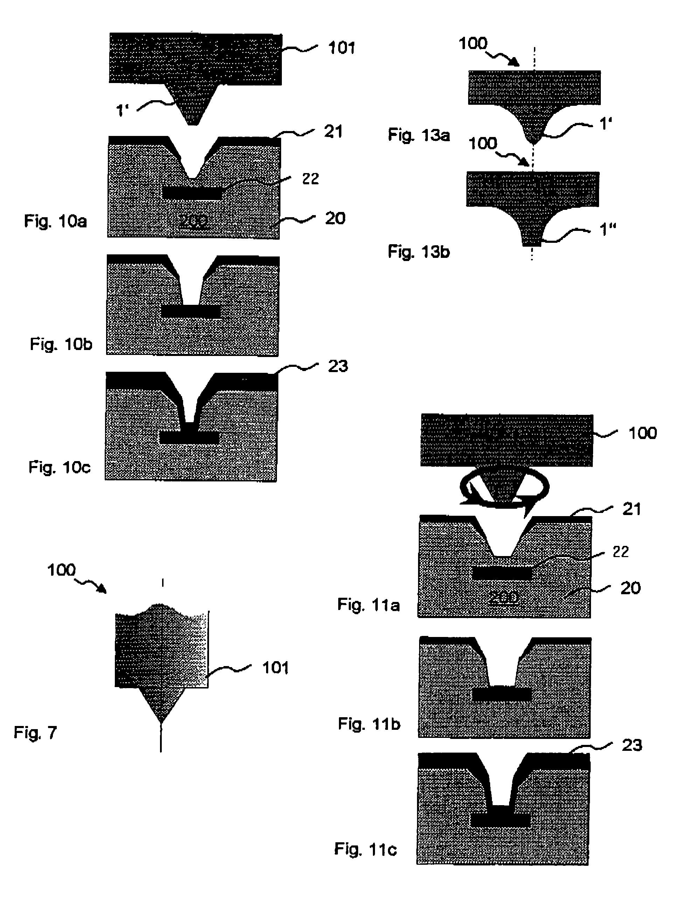

Fig. 7 zeigt schematisch einen Teil einer beispielhaften Prägevorrichtung 100, hergestellt in einem vorteilhaften Herstellungsverfahren. Die bisher beschriebenen Prägewerkzeuge beziehen sich weitgehend auf Prägematrizen. Zur Ausführung der Erfindung lassen sich aber auch Prägevorrichtungen wie elektronisch ansteuerbare Matrizen, in Analogie zu den Matrix-Druckern verwenden. Eine solche Prägevorrichtung wird beispielhaft in den Fig. 7 bis 9 dargestellt. Fig. 7 zeigt einen Teil einer vorteilhaften Prägevorrichtung 100 in Form einer nadelförmigen Erhebung 101 für einen Matrix-Drucker. Diese nadelförmige Erhebung ist bspw im Bereich der Spitze konisch, kegel- oder pyramidenförmig zugespitzt, wobei der Spitzenwinkel kleiner 90° ist. Besonders vorteilhaft aber nicht zwingend ist, dass die Nadel im Bereich der Spitze einen Absatz und eine konische Erhebung aufweist, welcher Absatz die Eindringtiefe beim Prägevorgang automatisch begrenzt. Die Nadeln sind vorteilhafterweise aus hartem und verschleissfestem Material.

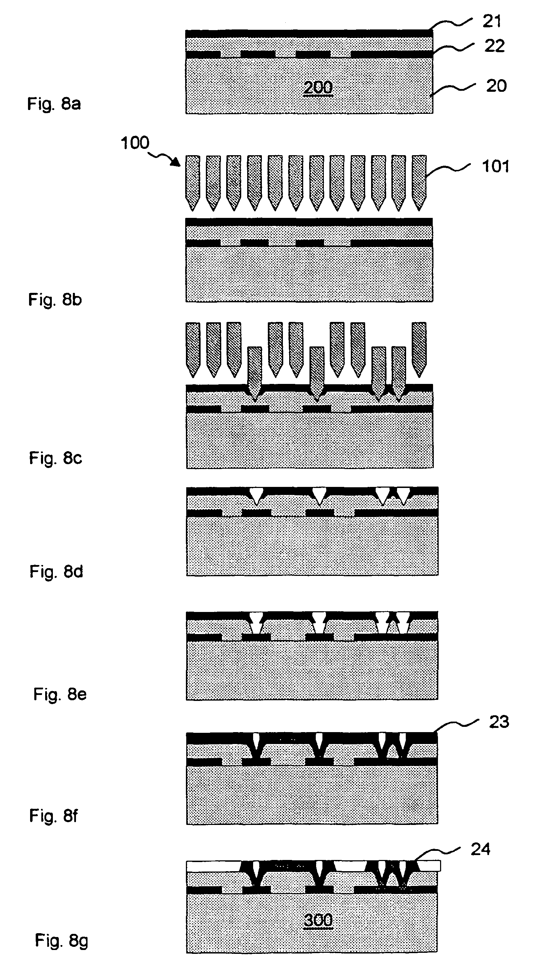

Fig. 8 zeigt ein weiteres beispielhaftes Herstellungverfahren von Leiterplattenhalbzeugen unter Verwendung einer Prägevorrichtung gemäss Fig. 7. Bei diesem weiteren Herstellungsverfahren wird eine Matrix-Prägevorrichtung 100 mit einer Vielzahl nadelförmiger Erhebungen 101 gegenüber einem Vorfabrikat 200 für Leiterplattenhalbzeuge positioniert (Fig. 8a und 8b). Jede einzelne der nadelförmigen Erhebungen ist elektronisch bspw. über einen Computer ansteuerbar. Die Nadeln sind vorteilhafterweise in einem bestimmten Raster, von bspw. 0.3 mm angeordnet. Um alle Punkte auf der Oberfläche des Vorfabrikats zu erreichen, wird bspw. das Vorfabrikat relativ zur Nadelmatrix-Prägevorrichtung in X- und Y-Richtung verfahren. Dabei kann entweder das Vorfabrikat und/oder die Matrix-Prägevorrichtung bewegt werden. Gemäss Fig. 8c und 8d werden bspw. Sacklöcher im Dielektrikum 20 geprägt. Hierzu werden Nadeln elektronisch aktiviert, sodass sie kleine konische Vertiefungen in die Oberfläche vom Vorfabrikat schlagen. Die Nadeln 101 sind an ihrer Spitze vorteilhafterweise so geformt, dass sie die mit leitfähigem Material 21 wie bspw. Kupfer durchstossen und kegelförmige Vertiefungen entstehen. Die Anschlagkraft ist vorteilhafterweise so steuerbar, dass die Tiefe dieser Mikrolöcher rund 80% des Abstandes zweier bspw. per Sackloch zu verbindenender Lagen elektrisch leitfähigen Materials beträgt. Da die kegelförmigen Vertiefungen nicht bis zur nächsten Ebene elektrisch leitfähigen Materials 22 reichen, wird der verbleibende Rest des bspw. organischen Dielektrikums durch einen weiteren abtragenden oder verdrängenden Prozess vertieft. Dies erfolgt bspw. im nachfolgenden Reinigungsschritt per Plasma oder per nasschemischer Verfahren, wobei bspw. geringe Unterätzungen entstehen (Fig. 8e). Dadurch wird die nächste Ebene elektrisch-leitfähigen Materials am Boden der Sacklöcher freigelegt. Gemäss Fig. 8f und Fig. 8g wird die gesamte exponierte Vorfabrikatoberfläche mit bekannten Verfahren mit elektrisch leitfähigem Material 23 wie bspw. Kupfer belegt, durchkontaktiert und photochemisch in Leiterbahnen 24 strukturiert. Das Leiterplattenhalbzeug 300 ist fertig.

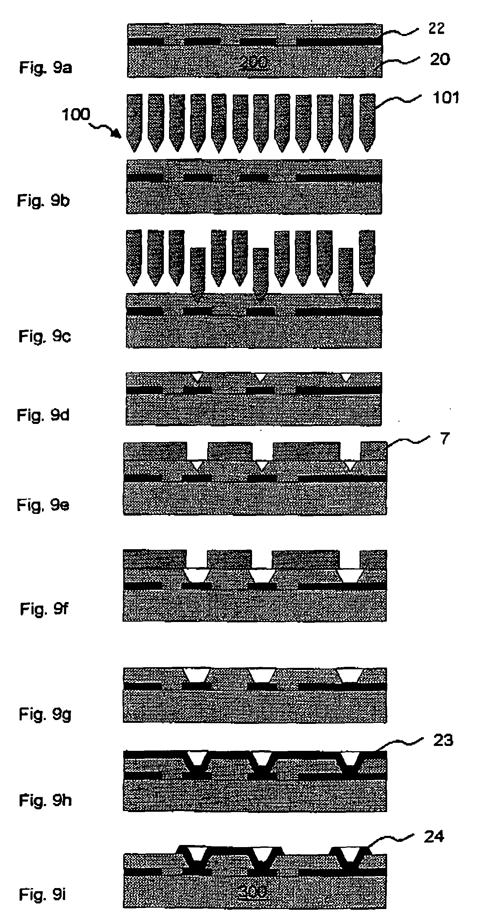

Fig. 9 zeigt ein weiteres Herstellungverfahren eines Leiterplattenhalbzeuges. Bei diesem weiteren Herstellungsverfahren wird im Unterschied zu Fig. 8 ein Vorfabrikat 200 ohne elektrisch leitfähiges Material in der äusseren Oberfläche verwendet (Fig. 9a). Die Matrix-Prägevorrichtung 100 muss somit keine Schicht aus bspw. Kupfer durchstossen (Fig. 9b). Gemäss Fig. 9c und 9d werden bspw. Sacklöcher im Dielektrikum 20 geprägt. Anschliessend werden solche Sacklöcher durch Plasma- oder nasschemische Verfahren vertieft und gereinigt. Gemäss Fig. 9e bis Fig. 9g werden bspw. abnehmbare Masken 7 aus bspw. Metall verwendet, die auf die zu reinigende und/oder zu vertiefende Vorfabrikatoberfläche gelegt werden und Ausnehmungen an den zu vertiefenden und/oder zu reinigenden Mikrolöchern aufweisen. Durch diese Ausnehmungen in den Masken werden die Vorfabrikatoberflächen nur im Bereich der Mikrolöcher bspw. mittels Plasmaeinwirkung vertieft und/oder gereinigt. Die nächste Ebene elektrischleitfahigen Materials am Boden der Sacklöcher wird somit freigelegt. Gemäss Fig. 9h und 9i wird die gesamte exponierte Vorfabrikatoberfläche mit bekannten Verfahren mit elektrisch leitfähigem Material 23 wie bspw. Kupfer belegt, durchkontaktiert und photochemisch zu Leiterbildern 24 strukturiert. Das Leiterplattenhalbzeug 300 ist fertig.

Die Vorteile der Verwendung einer Prägevorrichtung gegenüber derjenigen einer Prägematrize beruhen darauf:
dass keine Prägematrizen benötigt und somit auch nicht hergestellt werden müssen, das Verfahren ist somit unter Verwendung einer Prägevorrichtung
flexibler und anpassungsfähiger, dies insbesondere bei Änderungen bspw. im Schaltungsentwurf,
- dass die Nadelspitzen optimal geformt werden können, während eine durch Ätzen gestaltete Prägematrize nur eine bestimmte Form zulässt und
- dass das Herstellungsverfahren im Durchlauf, d.h. kontinuierlich durchführbar ist, in Analogie zum Bedrucken eines Blattes Papier.

Die Nachteile der Verwendung einer Prägevorrichtung gegenüber derjenigen eines Prägewerkzeuges liegen in den längeren Prozesszeiten. Dies bedeutet, dass für kleine Serien von Leiterplattenhalbzeugen und Leiterplatten die Verwendung einer Prägevorrichtung wie bspw. der beschriebene Matrix-Drucker wirtschaftlich von Vorteil ist, während für grosse Serien von Leiterplattenhalbzeugen und Leiterplatten die Verwendung von Prägewerkzeugen wie bspw. die beschriebenen Prägematrizen wirtschaftlich von Vorteil sind.

Fig. 10 und 11 zeigen schematisch Teile von weiteren beispielhaften Leiterplattenhalbzeugen, hergestellt unter Verwendung eines Prägewerkzeuges oder einer Prägevorrichtung. Die Beschreibung des Herstellungsverfahrens eines Leiterplattenhalbzeuges gemäss der Fig. 10 und 11 ähnelt den vorgängig beschriebenen Herstellungsverfahren, sodass auf diese Beschreibungen verwiesen wird und in der folgenden Beschreibung insbesondere Unterschiede der Herstellungsverfahren gemäss der Fig. 10 und 11 gegenüber den vorgängig beschriebenen Herstellungsverfahren hervorgehoben werden.

Ein Prägewerkzeug 100 oder eine Prägevorrichtung 100 gemäss Fig. 10a wird gegenüber einem Vorfabrikat 200 für Leiterplattenhalbzeuge positioniert und in einem Pressvorgang gegen das Vorfabrikat gepresst, wodurch sich die Spitzen 1' in das Vorfabrikat hineindrücken und aussenseitig angebrachtes elektrisch leitfähiges Material 21 wie bspw. Kupfer sowie dielektrisches Harz 20 lokal verdrängen (Fig. 10b). Durch das Prägen oder Piercen entstehen sehr kleine, sogenannte Mikrolocher. Dementsprechend ist die Kontaktfläche zum nächsttieferliegenden elektrisch leitfahigen Material 22 sehr klein. Diese Vertiefungen dienen bspw. zum Herstellen von durchzukontaktierenden Sacklöchem.

Am Grunde der geprägten Mikrolöcher wird das Harz durch Prägen alleine nicht vollständig verdrängt, was eine gründliche Nachreinigung dieser Mikrolöcher erforderlich macht. Diese kann mittels Plasma oder auch nasschemischer Verfahren erfolgen. Die Vertiefungen werden dabei bis zur nächsten innenliegenden elektrisch leitfähigen Materiallage aus bspw, Kupfer vergrössert, sodass Kontaktflächen für herzustellende Sacklöcher freigelegt werden (Fig. 10b).

Gemäss Fig. 10c kann anschliessend das entstandene Leiterplattenhalbzeug genau wie herkömmlich hergestellte mittels bekannter Verfahren mit elektrisch leitfähigem Material 23 wie bspw. Kupfer belegt und durchkontaktiert. Eine photochemische strukturierung der Leiterbahnen, etc. und eine Weiterverarbeitung zu einem Leiterplattenhalbzeug 300 ist somit, wie bereits vorgängig beschrieben und gezeigt, möglich.

Um ein Durchstechen von dünnen Schichten elektrisch leitfähigen Materials sicher zu gewährleisten, müssen die Erhöhungen von Prägewerkzeug bzw. Prägevorrichtung recht spitz gestaltet sein. Dies führt wiederum zu sehr kleinen Mikrotöchern. Die Durchmesser vom Lochgrund dieser Mikrolöcher lassen sich wie bereits vorgängig beschrieben durch Plasmaeinwirkung oder durch nasschemische Verfahren erweitern, sodass innenliegendes elektrisch leitfähiges Material als Kontaktflächen für bspw. herzustellende Sacklöcher freigelegt werden. Eine solche Vergrösserung ist gemäss Fig. 11a aber auch durch ein rotierendes Vibrieren des Prägewerkzeuges 100 oder Prägevorrichtung 100 möglich. Eine solche rotierende Vibration wird durch den kreisförmig geschlossenen Pfeil in Fig. 11a angedeutet Vibrationen lassen sich dem Prägewerkzeug bzw. der Prägevorrichtung mittels bekannter Methoden aufzwingen. Diese Vibrationen der Spitzen erfolgen vorzugsweise in kreisförmiger Richtung und bewirken, dass die im Dielektrikum 20 vom Vorfabrikat 200 eingesteckten Spitzen die Vertiefungen kreisförmig aufweiten und vertiefen (Fig. 11b). Die Lochgrössen lassen sich somit über die Amplitudengrösse der Vibrationen bestimmen Eine nachfolgende Reinigung mittels Plasma oder nasschemischer Verfahren ist möglich aber nicht zwingend. Gemäss Fig. 11c wird anschliessend das entstandene Leüerplattenhalbzeug mittels bekannter Verfahren mit elektrisch leitfähigem Material 23 wie bspw. Kupfer belegt und durchkontaktiert. Eine photochmische Strukturierung von Leiterbahnen, usw ist somit, wie bereits vorgängig beschrieben und gezeigt, möglich.

Vorteilhaft an einer solchen mechanischen Locherweiterung bzw. Vertiefung ist, dass nachfolgende Reinigungsvetfahren drastisch verkürzt werden, was positive Auswirkungen auf die Wirtschaftlichkeit hat. Vorteilhaft an einer solchen mechanischen Locherweiterung ist ferner, dass die Kontaktflache am Boden der Sacklöcher vergrössert wird, was die Zuverlässigkeit der Z-Achsenverbindung erhöht.

Andere Bewegungen und Richtungen der vibrierenden Spitzen sind bei Kenntnis der vorliegenden Erfindung durchaus möglich, dem Fachmann stehen hierbei vielfältige Variationen zur Verfügung. So ist es bspw. möglich, bei der Herstellung von Durchgangslöchern, wo Prägewerkzeuge bzw. Prägevorrichtungen beidseitig auf ein Vorfabrikat gepresst werden, die Spitzen von auf unterschiedlichen Seiten des Vorfabrikats angebrachten Prägewerkzeugen bzw. Prägevornchtungen gegenläufig vibrieren zu lassen.

Fig. 12 zeigt schematisch einen Teil eines weiteren beispielhaften Leiterplattenhalbzeuges, hergestellt unter Verwendung eines Prägewerkzeuges oder einer Prägevorrichtung sowie unter Verwendung einer elastischen Zwischenschicht. Die Beschreibung des Herstellungsverfahrens eines Leiterplattenhalbzeuges gemäss der Fig. 12 ähnelt den vorgängig beschriebenen Herstellungsverfahren, sodass auf diese Beschreibungen verwiesen wird und in der folgenden Beschreibung insbesondere Unterschiede der Herstellungsverfahren gemäss der Fig. 12 gegenüber den vorgängig beschriebenen Herstellungsverfahren hervorgehoben werden.

Gemäss Fig. 12a wird ein Prägewerkzeug 100 oder eine Prägevorrichtung 100 mit elastischer Zwischenschicht 4 gegenüber einem Vorfabrikat 200 für Leiterplattenhalbzeuge positioniert und in einem Pressvorgang gegen das Vorfabrikat gepresst, wodurch sich die Spitzen 1' in das Vorfabrikat hineindrücken und aussenseitig angebrachtes elektrisch leitfähiges Material 21 wie bspw. Kupfer sowie dielektrisches Harz 20 lokal verdrängen (Fig. 12b). Die elastische Zwischenschicht des Prägewerkzeuges bzw.- der Prägevorrichtung erlaubt eine Anpassung an eventuelle Variationen in der Dicke der zu prägenden Halbzeuge, die sich beim Prägen negativ auswirken können. Fig. 12a zeigt ein solches, beispielhaftes Vorfabrikat mit unterschiedlicher Dicke. Der Einsatz einer elastischen Zwischenschicht erfolgt vorteilhafterweise zwischen dem Prägewerkzeug bzw. der Prägevorrichtung und der eigentlichen Druckplatte. Die elastische Zwischenschicht passt sich beim Anpressen an das Vorfabrikat dessen Unebenheiten an und ermöglicht somit ein Prägen mit gleichmässiger Prägetiefe. Anschliessend erfolgt eine Reinigung mittels Plasma oder nasschemischer Verfahren. Anschliessend lässt sich das Leiterplattenhalbzeug mittels bekannter Verfahren mit elektrisch leitfähigem Material wie bspw. Kupfer belegen und durchkontaktieren. Auch ist eine photochemische Strukturierung der Leiterbahnen, etc., wie vorgängig beschrieben und gezeigt, möglich.

Fig. 14 zeigt schematisch einen Teil eines Leiterplattenhalbzeuges mit gestanzten Fehlern, hergestellt unter Verwendung eines nachteiligen Prägewerkzeuges gemäss Fig. 13b. Die Beschreibung des Herstellungsverfahrens eines Leiterplattenhalbzeuges gemäss der Fig. 14 ähnelt den vorgängig beschriebenen Herstellungsverfahren, sodass auf diese Beschreibungen verwiesen wird und in der folgenden Beschreibung insbesondere Unterschiede der Herstellungsverfahren gemäss der Fig. 14 gegenüber den vorgängig beschriebenen Herstellungsverfahren hervorgehoben werden.

Die Gestalt der Spitze eines Prägewerkzeuges bzw. einer Prägevorrichtung ist sehr wichtig. Dies deshalb, weil wie bspw. die in Fig. 13b gezeigte abgeflachte Spitze 1" zu einer Art Stanzvorgang führt. Ein solcher nachteiliger Stanzvorgang wird in Fig. 14 beispielhaft gezeigt. Gemäss Fig. 14a ist ein Prägewerkzeug oder eine Prägevorrichtung 100 mit abgeflachten Spitzen 1" gegenüber einem Vorfabrikat 200 für Leiterplattenhalbzeuge positioniert und wird in einem Pressvorgang gegen das Vorfabrikat gepresst, wodurch sich die Spitzen in das Vorfabrikat hineindrücken und aussenseitig angebrachtes elektrisch leitfähiges Material 21 wie bspw. Kupfer sowie dielektrisches Harz 20 lokal verdrängen (Fig. 14b und 14c). Durch das Prägen entstehen Vertiefungen oder Mikrolöcher zum Herstellen von bspw. durchzukontaktierenden Sacklöchem. Durch die abgeflachten Spitzen werden beim Prägen kleine Kupferrondellen 211 aus der aussenseitig angebrachten elektrischen Leitschicht ausgestanzt und nach innen, gegen die nächste Lage elektrisch leitfähigen Materials 22. gedrückt (Fig. 14c). Dabei befindet sich zwischen der Kupferrondelle und der darunterliegender Lage dektrisch leitfähigen Materials eine dünne Schicht Dielektrikum. Bei einer nachfolgenden Reinigung der Vertiefungen mittels Plasma oder nasschemischer Verfahren kann durch eine Kupferrondelle abgedecktes Dielektrikum nicht mehr entfernt werden. Eine Herstellung von Sacklöchem wird somit verhindert.

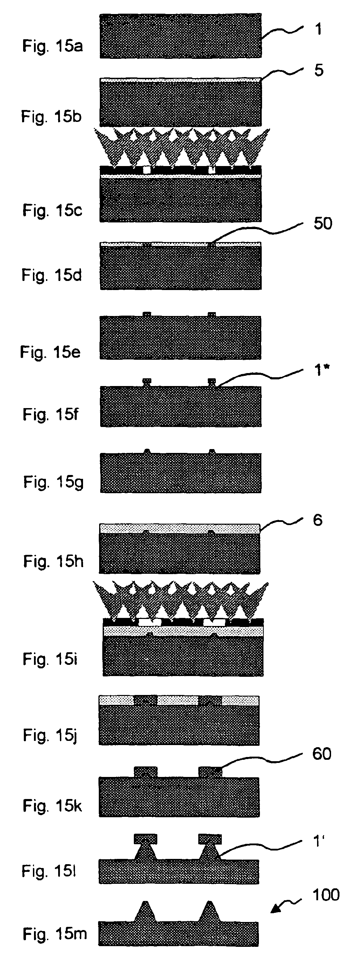

Solche Stanzfehler werden bei Verwendung von Prägewerkzeugen bzw. Prägevorrichtungen mit Spitzen mit scharfen Erhöhungen vermieden. Fig. 13a und Fig. 15 zeigen schematisch Teile von weiteren Prägewerkzeugen.

Fig. 13a zeigt eine Spitze 1', die verglichen mit der nachteiligen abgeflachten Spitze gemäss Fig. 13b, in einem elektrochemischen Polierprozess abgerundet worden ist. Vorteilhafterweise wird hierzu die Prägematrize mit abgeflachten Spitzen 1" gemäss Fig. 13b elektrisch anodisch geschaltet, sodass Kanten und Mikrospitzen in einem Ätzprozess schneller abgetragen werden als flache Bereiche. Das Ergebnis ist die scharfe Spitze 1' gemäss Fig. 13a. Dem Fachmann stehen bei Kenntnis der vorliegenden Erfindung vielfältige Möglichkeiten der Variation zur Verfügung. So ist es durchaus möglich, abgeflachte Spitzen durch einen Sandstrahl-Prozess abzurunden. Auch ist es möglich, abgeflachte Spitzen einem nasschemischen Ätzprozess abzurunden.

Fig. 15 zeigt ein weiteres Herstellungsverfahren von beispielhaften Prägewerkzeugen mit Spitzen mit scharfen Erhöhungen. Ausgangsmaterial ist gemäss Fig. 15a eine Folie bzw. ein Blech bspw. aus Metall 1. In einer ersten photochemischen Strukturierung wird gemäss Fig. 15b eine dünne Schicht Photoresist 5 auf die Ausgangsmaterialoberfläche aufgetragen und über eine Filmvorlage belichtet (Fig. 15c). An allen belichteten Oberflächenbereichen wird der Photoresist gehärtet (Fig. 15d). Nach Entwicklung dieser Photoresistschicht bleibt wie in Fig. 15e gezeigt, nur gehärteter Photoresist 50 auf der Ausgangsmaterialoberfläche haften. Dieser Photoresist bildet vorteilhafterweise kreisrunde oder auch mehreckige Inselbereiche von 25-100 µm Durchmesser.

Anschliessend wird diese Ausgangsmaterialoberfläche mit einem geeigneten Ätzmedium geätzt (Fig. 15f). Bei Verwendung einer Ätztiefe von 10-50 µm entstehen im Bereich der Resistinseln kleine Erhöhungen 1* von 10-50 µm Durchmesser. Der Photoresist wird daraufhin gestrippt (Fig. 15g).

In einer weiteren photochemischen Strukturierung gemäss Fig. 15h wird eine weitere Schicht Photoresist 6 auf die mit kleinen Erhöhungen versehenen Ausgangsmaterialoberfläche aufgetragen und über eine Filmvorlage belichtet (Fig. 15i). An allen belichteten Oberflächenbereichen wird der weitere Photoresist gehärtet (Fig. 15j). Nach Entwicklung dieser Photoresistschicht bleibt wie in Fig. 15k gezeigt, nur gehärteter Photoresist 60 auf der Ausgangsmaterialoberfläche haften. Dieser Photoresist bildet vorteilhafterweise kreisrunde und auch mehreckige Inselbereiche von 100-300 µm Durchmesser.

Nun wird diese Ausgangsmaterialoberfläche mit einem geeigneten Ätzmedium ein weiteres Mal geätzt (Fig. 151). Bei Verwendung einer Ätztiefe von 100-300 µm entstehen im Bereich der Resistinseln kleine Erhöhungen 1' von 100-300 µm Durchmesser. Der Photoresist wird daraufhin gestrippt (Fig. 15m). Das Prägewerkzeug 100 ist fertiggestellt.

## Patentansprüche

1. Verfahren zur Herstellung von Mikrolöchern in Halbzeugen (300) für Leiterplatten, welche Halbzeuge (300) aus mehreren Schichten elektrisch leitfähiger Materialien (21,22) und einer oder mehrerer Schichten eines Dielektrikums (20) bestehen, wobei Löcher in Dielektrika und/oder in elektrisch leitfähigen Materialien von Vorfabrikaten (200) geprägt werden, **dadurch gekennzeichnet, dass** zur Prägung der Löcher Prägewerkzeuge (100) oder Prägevorrichtungen (100) gegen die Vorfabrikate (200) gepresst werden, dass von Vorfabrikaten (200) ausgegangen wird, welche eine mindestens teilweise bedeckende äusserste leitende Schicht (21) aufweisen, dass die Prägewerkzeuge (100) oder Prägevorrichtungen (100) auf der Seite der äussersten leitenden Schicht (21) gegen die Vorfabrikate (200) gepresst werden, und dass die Löcher mittels Plasma oder mittels nasschemischer Verfahren nachgereinigt werden.

2. Verfahren nach Anspruch 1, **dadurch gekennzeichnet, dass** die leitende Schicht (21) vorstrukturierte Öffnungen aufweist und dass Erhebungen des Prägewerkzeugs so positioniert werden, dass sie lagemässig mit vorstrukturierten Öffnungen übereinstimmen.

3. Verfahren nach Anspruch 1, **dadurch gekennzeichnet, dass** durch Prägewerkzeuge oder Prägevorrichtungen elektrisch leitfähige Materialien der Schicht (21) in Dielektrika hineingedrückt werden.

4. Verfahren nach einem der vorangehenden Ansprüche, **dadurch gekennzeichnet, dass** nach dem Prägen der Löcher leitfähiges, dem Material der Schicht (21) entsprechendes Material aufgalvanisiert wird.

5. Verfahren nach einem der vorangehenden Ansprüche, **dadurch gekennzeichnet, dass** die Löcher durch Plasma oder mittels nasschemischer Verfahren vertieft, vergrössert und gereinigt werden.

6. Verfahren gemäss einem der vorangehenden Ansprüche, **dadurch gekennzeichnet, dass** Masken (7) mit Ausnehmungen im Bereich der Mikrolöcher auf Vorfabrikatoberflächen gelegt werden und dass die Vorfabrikatoberflächen durch diese Ausnehmungen in den Masken nur im Bereich der Löcher mittels Plasma oder nasschemisch vertieft und/oder gereinigt werden.

7. Verfahren nach einem der vorangehenden Ansprüche, **dadurch gekennzeichnet, dass** die Erhebungen konisch sind.

8. Verfahren gemäss Anspruch 7, **dadurch gekennzeichnet, dass** Prägewerkzeuge oder Prägevornchtungen mit konischen Erhebungen gegen Vorfabrikate gepresst und in rotierende Vibration versetzt werden, wodurch die konischen Erhebungen in elektrisch leitfähige Materialien und/oder Dielektrika hineingedrückt werden und die dabei entstehenden Löcher durch Vibration vergrössert werden.

9. Verfahren gemäss Anspruch 8, **dadurch gekennzeichnet, dass** Prägewerkzeugen oder Prägevorrichtungen Vibrationen aufgezwungen werden, die die geprägten Löcher kreisförmig aufweiten und vertiefen und dass die Lochgrössen über die Amplitudengrösse der Vibrationen bestimmt werden.

10. Verfahren gemäss einem der Anspüche 7 bis 9, **dadurch gekennzeichnet, dass** Prägewerkzeuge oder Prägevorrichtungen aufgrund der konischen Ausformung der Erhebungen einfach von Vorfabrikaten gelöst werden.

11. Verfahren gemäss einem der vorangehenden Ansprüche, **dadurch gekennzeichnet, dass** Prägewerkzeuge oder Prägevorrichtungen durch zwischen den Prägewerkzeugen oder Prägevorrichtungen und Druckplatten angeordnete elastische Zwischenschichten (4) mit gleichmässigen Prägetiefen in unebene Vorfabrikate gepresst werden.

12. Halbzeug (300) für Leiterplatten aus mehreren Schichten elektrisch leitfähiger Materialien (21, 22) und einer oder mehrerer Schichten eines Dielektrikums (20), **dadurch gekennzeichnet, dass** Löcher in elektrisch leitfähige Materialien und in Dielektrika eines Halbzeugs (200) mit einer mindestens teilweise bedeckenden äussersten leitfähigen Schicht (21) hineingedrückt und mittels Plasma oder nasschemischer Verfahren nachgereinigt sind.

13. Prägevorrichtung zur Herstellung von Löchern in Halbzeugen für Leiterplatten mit einer Vielzahl von konischen Erhebungen in Form von einzeln und elektronisch über einen Computer ansteuerbarbaren Nadeln (101), wobei die Nadeln in einem Raster angeordnet sind und das Vorfabrikat und das Raster der Nadeln zueinander bewegbar sind, und wobei die Nadeln elektronisch aktivierbar sind und Mittel zum Schlagen kleiner konische Vertiefungen in die Oberfläche des Vorfabrikats aufweisen, und die Anschlagkraft der Nadeln steuerbar ist, sodass die Tiefe der Mikrolöcher rund 80% des Abstandes von zu verbindenenden Lagen elektrisch leitfähigen Materials beträgt.

## Claims

1. Method for the production of micro-holes in semi-finished components (300) for printed circuit boards, which semi-finished components (300) consist of several layers of electrically conductive materials (21,22) and one or more layers of a dielectric material (20), wherein holes are embossed into dielectric materials and/or electrically conductive materials of prefabricated components (200), **characterized in that** for the embossing of the holes embossing dies (100) or embossing devices (100) are pressed against the prefabricated components (200), that prefabricated components (200) comprising an at least partially covering outermost conductive layer (21) are used, that the embossing dies (100) or embossing devices (100) are pressed against the prefabricated components (200) on the side of the outermost electrically conductive layer, and that the holes are subsequently cleaned by means of plasma or by means of wet-chemical processes.

2. Method according to claim 1, **characterized in that** the electrically conductive layer (21) has pre-structured openings and that the protrusions of the embossing die are positioned in such a manner, that they coincide with the position of the pre-structured openings.

3. Method according to claim 4, **characterized in that** electrically conductive materials of the layer (21) are pressed into dielectric materials by embossing dies or embossing devices.

4. Method according to one of the preceding claims, **characterized in that** following the embossing of the holes conductive material corresponding to the material of the layer (21) is applied by means of electro-plating.

5. Method according to one of the preceding claims, **characterized in that** the holes are deepened, enlarged, and cleaned by means of plasma or by means of wet-chemical processes.

6. Method according to one of the preceding claims, **characterized in that** masks (7) with recesses in the range of the micro-holes are placed onto surfaces of the prefabricated components and that through these recesses in the masks the surfaces of the prefabricated components are deepened and/or cleaned by means of plasma or wet-chemical processes only in the area of the holes.

7. Method according to one of the preceding claims, **characterized in that** the protrusions are conical.

8. Method according to claim 7, **characterized in that** embossing dies or embossing tools with conical protrusions are pressed against prefabricated components and are set into rotating vibration, as a result of which the conical protrusions are pressed into electrically conductive materials and/or dielectric materials and the holes thus generated are enlarged through vibration.

9. Method according to claim 8, **characterized in that** vibrations are imposed upon embossing dies or embossing tools, which enlarge and deepen the embossed holes in a circular fashion and that the hole sizes are determined by the amplitude size of the vibrations.

10. Method according to one of the claims 7 to 9, **characterized in that**, due to the conical design of the protrusions, embossing dies and embossing devices are easily removed from the prefabricated components.

11. Method according to one of the preceding claims, **characterized in that** embossing tools or embossing devices are pressed, with uniform embossing depths, through elastic intermediate layers (4) arranged between the embossing dies or embossing devices and pressure plates into uneven prefabricated components.

12. Semi-finished component (300) for printed circuit boards consisting of several layers of electrically conductive materials (21,22) and one or several layers of a dielectric material (20), **characterized in that** holes are pressed into electrically conductive materials and into dielectric materials of a semi-finished component (200) with an at least partially covering outermost electrically conductive layer (21) and subsequently cleaned by means of plasma or by means of wet-chemical processes.

13. Embossing device for the production of holes in semi-finished components for printed circuit boards with a multitude of conical protrusions being individually and electronically computer-controllable needles (101), wherein the needles are arranged in a grid pattern, and the prefabricated component and the grid pattern of needles can be moved in relation to one another, and wherein the needles can be activated and comprise means to punch small conical indentations into the surface of the prefabricated component, and the striking force of the needles is controllable, so that the depth of the micro-holes amounts to about 80 % of the spacing between the layers of electrically conductive material to be connected.

## Revendications

1. Procédé de formation de microtrous dans des ébauches (300) de cartes de circuit électrique,
les ébauches (300) étant constituées de plusieurs couches de matériaux électriquement conducteurs (21, 22) et d'une ou plusieurs couches d'un diélectrique (20),
les trous étant formés dans les diélectriques et/ou dans les matériaux électriquement conducteurs de préfabriqués (200),
**caractérisé en ce que**
pour former les trous, des outils d'emboutissage (100) ou des dispositifs d'emboutissage (100) sont repoussés contre les préfabriqués (200),
**en ce que** l'on part de préfabriqués (200) qui sont recouverts au moins en partie par une couche conductrice extérieure (21),
**en ce que** les outils d'emboutissage (100) ou les dispositifs d'emboutissage (100) sont repoussés contre le côté des préfabriqués (200) qui présente la couche conductrice extérieure (21) et
**en ce que** les trous reçoivent un nettoyage final par plasma ou à l'aide d'un procédé chimique en conditions humides.

2. Procédé selon la revendication 1, **caractérisé en ce que** la couche conductrice (21) présente des ouvertures préstructurées et **en ce que** les reliefs de l'outil d'emboutissage sont disposés de manière à ce que leur position corresponde à celle des ouvertures préstructurées.

3. Procédé selon la revendication 1, **caractérisé en ce que** les outils d'emboutissage ou les dispositifs d'emboutissage enfoncent des matériaux électriquement conducteurs de la couche (21) dans les diélectriques.

4. Procédé selon l'une des revendications précédentes, **caractérisé en ce qu'**après l'emboutissage des trous, un matériau conducteur qui correspond au matériau de la couche (21) est appliqué par galvanisation.

5. Procédé selon l'une des revendications précédentes, **caractérisé en ce que** les trous sont approfondis, agrandis et nettoyés par plasma ou au moyen d'un procédé chimique en conditions humides.

6. Procédé selon l'une des revendications précédentes, **caractérisé en ce que** des masques (7) qui présentent des découpes dans la zone occupée par les microtrous sont appliqués sur les surfaces des préfabriqués et **en ce que** dans la zone occupée par les trous, les surfaces des préfabriqués sont approfondies et/ou nettoyées par plasma ou chimiquement en conditions humides uniquement à travers ces découpes ménagées dans les masques.

7. Procédé selon l'une des revendications précédents, **caractérisé en ce que** les reliefs sont coniques.

8. Procédé selon la revendication 7, **caractérisé en ce que** des outils d'emboutissage ou des dispositifs d'emboutissage à reliefs coniques sont repoussés contre des préfabriqués et sont mis en vibration rotative, ce qui enfonce les saillies coniques dans les matériaux électriquement conducteurs et/ou les diélectriques, pour ainsi agrandir par vibration les trous ainsi formés.

9. Procédé selon la revendication 8, **caractérisé en ce que** des vibrations qui agrandissent en cercle les trous emboutis et les approfondissent sont appliquées par les outils d'emboutissage ou les dispositifs d'emboutissage et **en ce que** la taille des trous est définie par le niveau d'amplitude des vibrations.

10. Procédé selon l'une des revendications 7 à 9, **caractérisé en ce que** les outils d'emboutissage ou les dispositifs d'emboutissage sont libérés aisément des préfabriqués grâce à la forme conique des reliefs.

11. Procédé selon l'une des revendications précédentes, **caractérisé en ce que** les outils d'emboutissage ou les dispositifs d'emboutissage sont repoussés à une profondeur uniforme d'emboutissage dans des préfabriqués non plan par des couches intermédiaires élastiques (4) disposées entre les outils d'emboutissage ou les dispositifs d'emboutissage et les plaques de poussée.

12. Ebauche (300) de cartes de circuit constituée de plusieurs couches de matériau électriquement conducteur (21, 22) et d'une ou plusieurs couches d'un diélectrique (20),
**caractérisée en ce que**
des trous sont emboutis dans les matériaux électriquement conducteurs et dans les diélectriques d'une ébauche (200) recouverte au moins en partie d'une couche extérieure conductrice (21) et sont nettoyés par plasma ou par un procédé chimique en conditions humides.

13. Dispositif d'emboutissage en vue de la réalisation de trous dans des ébauches de cartes de circuit, présentant plusieurs reliefs coniques qui présentent la forme d'aiguilles (101) commandées séparément et électroniquement par un ordinateur, les aiguilles étant disposées suivant une trame et le préfabriqué et la trame des aiguilles pouvant être déplacés l'un par rapports à l'autre, les aiguilles pouvant être activées électroniquement et présentant des moyens permettant de former de petits creux coniques dans la surface du préfabriqué, la force de poussée des aiguilles pouvant être commandée de telle sorte que la profondeur des microtrous représente environ 80 % de la distance entre des couches de matériau électriquement conducteur qui doivent être reliées.
